# FASCICULE DE BREVET EUROPEEN

(11) **EP 1 311 903 B1**
(45) Date de publication et mention de la délivrance du brevet: **30.06.2004**
(21) Numéro de dépôt: 01960545.0
(22) Date de dépôt: 23.07.2001
(51) Int. Cl.: G03B 17/12

(54) **Appareil de prise d'images de petites dimensions, notamment appareil photographique ou camera**
Vorrichtung zur Aufnahme von Bildern Kleiner Abmessungen, insbesondere Photoapparat oder Videokamera
Small-size imaging apparatus, in particular photographic appliance or camera

(30) Priorité: 11.08.2000 EP 00202834
(43) Date de publication de la demande: 21.05.2003
(73) Titulaire: EM Microelectronic-Marin SA, CH-2074 Marin (CH)
(72) Inventeur: DOERING, Elko, CH-2572 Mörigen (CH); GRUPP, Joachim, CH-2073 Enges (CH); PFEFFERLI, Beat, CH-2075 Thielle-Wavre (CH)
(74) Mandataire: Surmely, Gérard
(86) Numéro de dépôt international: PCT/EP2001/008532
(87) Numéro de publication internationale: WO 2002/014948

(56) Documents cités:
- US-A- 5 130 804
- US-A- 5 786 589
- US-A- 6 011 294
- US-A- 6 011 661
- DATABASE WPI Section EI, Week 200067 Derwent Publications Ltd., London, GB; Class T04, AN 2000-681661 XP002158824 -& JP 2000 196808 A (KYOCERA CORP), 14 juillet 2000 (2000-07-14)
- PATENT ABSTRACTS OF JAPAN vol. 2000, no. 07, 29 septembre 2000 (2000-09-29) -& JP 2000 111777 A (TAIHEIYO BOEKI KK), 21 avril 2000 (2000-04-21)
- PATENT ABSTRACTS OF JAPAN vol. 1999, no. 11, 30 septembre 1999 (1999-09-30) -& JP 11 167054 A (MATSUSHITA ELECTRIC IND CO LTD), 22 juin 1999 (1999-06-22)

## Description

La présente invention concerne un appareil de prise d'images de petites dimensions, notamment un appareil photographique ou une caméra, dans lequel il est prévu un capteur formé d'une pluralité de pixels servant à la détection d'images. Cet appareil comprend au moins une lentille de focalisation dont l'axe optique croise sensiblement le centre géométrique de la surface photosensible du capteur.

En particulier, l'appareil de prise de vue selon l'invention est destiné à être incorporé dans un dispositif portable multifonctionnel, notamment un téléphone mobile, une montre ou un micro-ordinateur portable.

Il est connu du document US 5,130,804 un appareil de prise d'images comprenant un capteur, une lentille agencée dans un châssis et un support présentant une ouverture en regard de laquelle sont agencées de part et d'autre de ce support la lentille et une surface photosensible dudit capteur. Le capteur lui-même est formé d'un substrat définissant la surface photosensible, ce substrat étant agencé au fond d'un boîtier auquel il est relié électriquement de manière classique. Ce boîtier comprend des liaisons électriques reliant le substrat à des plages de contact externes du boîtier pour permettre une connexion électrique audit support sur lequel sont montées des unités électroniques. De plus, le boîtier présente un décrochement dans la paroi de son ouverture pour la pose d'une lame de verre servant à fermer cette ouverture (voir figures 4, 6 et 7).

L'appareil décrit ci-avant présente l'inconvénient d'être relativement onéreux car le capteur lui-même est relativement complexe. Ensuite, la connexion électrique entre le substrat de la surface photosensible et le support des unités électroniques est réalisée en deux étapes nécessitant une première connexion à l'aide de fils de soudure outre la face supérieure du substrat et le fond du boîtier. Cette connexion est fragile. De plus, le capteur présente des dimensions relativement grandes, en particulier son épaisseur.

Un but de la présente invention est de pallier les inconvénients mentionnés ci-dessus en fournissant un appareil de prise d'images ayant des dimensions minimales et qui soit facilement intégrable dans un dispositif portable.

Un autre but de l'invention est de fournir un tel appareil dans lequel les connexions électriques entre les pixels du capteur et l'unité électronique de traitement et/ou d'exploitation des signaux électroniques fournis par ces pixels sont établies aisément et de manière fiable.

Finalement, un autre but de l'invention est de fournir un tel appareil qui soit compact et d'assemblage aisé pour une fabrication peu onéreuse.

L'appareil selon l'invention présente une hauteur minimale et une bonne rigidité. Le capteur et ses connexions électriques qui forment la partie fragile de cet appareil sont correctement protégés et fiables. De plus, les connexions électriques du capteur aux unités électroniques périphériques sont établies sans fils de soudure.

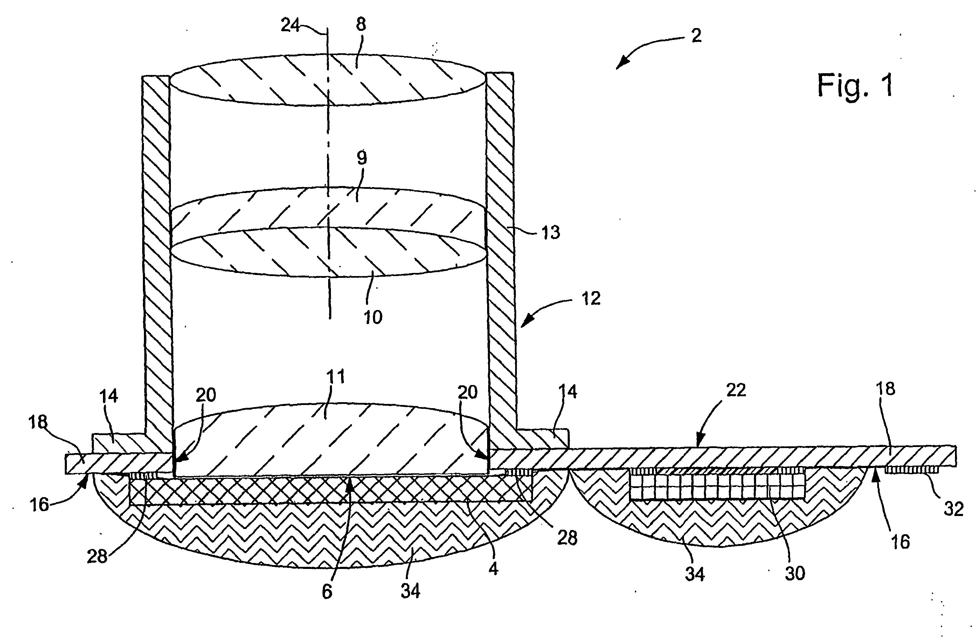

La présente invention sera décrite ci-après en détail à l'aide de la description suivante, faite en référence à la figure 1 donnée à titre d'exemple nullement limitatif et représentant schématiquement un mode de réalisation préféré d'un appareil de prise d'images.

Sur la figure 1 est représenté schématiquement un appareil de prise d'images 2 formant un module compact et autonome. Cependant, il est destiné à être intégré dans un dispositif portable, notamment un téléphone ou un objet portable au poignet comme une montre. Cet appareil est formé d'un capteur d'images 4 présentant une surface photosensible 6 et d'un objectif comprenant des lentilles de focalisation 8, 9, 10 et un élément optique 11 montés dans un châssis 12 définissant un tube 13 ouvert à ses deux extrémités et un flasque 14 situé au niveau de l'extrémité interne du tube, c'est-à-dire du côté du capteur. Le capteur 4 est monté sur la face inférieure 16 d'un support 18 qui présente une ouverture 20 aux dimensions sensiblement égales ou supérieures à celles de la surface photosensible 6 qui est située en regard de cette ouverture de manière sensiblement centrée sur cette dernière. Le flasque 14 est fixé à la face supérieure 22 du support 18 de manière que l'axe optique 24 des lentilles 8 à 10 passe sensiblement par le centre géométrique de l'ouverture et de la surface photosensible.

L'élément optique 11 forme ici une lentille, mais il peut aussi être une simple lame transparente formant un filtre UV par exemple.

Le châssis 12 peut être fixé au support 18 de diverses manières à disposition de l'homme du métier, notamment par collage. Divers moyens de positionnement peuvent être prévus, en particulier des goupilles agencées dans le substrat ou dans le flasque. Le châssis peut aussi être monté par vissage ou autres moyens équivalents.

Le capteur 4 est formé d'un substrat semiconducteur à la surface duquel. sont agencés des pixels définissant la surface photosensible 6. Ces pixels sont reliés par des pistes électriques à des plots 28 de contact électrique avec des plages correspondantes agencées à la face inférieure 16 du support. A cette face 16 sont agencées diverses pistes conductrices reliant les plages de contact au capteur 4 avec au moins une unité électronique 30 agencée sur cette face 16. Des plages de contact périphériques 32 peuvent également être prévues pour fournir les images traitées ou partiellement traitées à des moyens d'exploitation, notamment des moyens d'affichage des images prises par l'appareil 2. Les plots ou plages de contact électrique peuvent dans d'autres variantes être remplacé(e)s respectivement par des plages ou plots.

Le capteur 4 et l'unité électronique 30 sont protégés au moyen d'une résine 34. Cette résine 34 rigidifie également la partie arrière du support 18 et assure le maintien des liaisons électriques entre les plages de contact agencées sur ce support et les plages ou plots de connexion 28 du capteur. On notera en effet que le capteur 4 peut ne présenter que des plages de contact formées d'une fine métallisation en surface, la connexion électrique étant réalisée au moyen d'une colle conductrice anisotrope ou d'un autre conducteur intermédiaire connu de l'homme du métier.

On notera également que dans une autre variante de réalisation l'élément optique 11 n'est pas prévu.

On notera finalement que le support 18 peut avantageusement avoir une partie souple pliable entre une première partie supportant le capteur et l'objectif et une deuxième partie supportant d'autres unités, notamment l'unité électronique 30. Ceci permet de rabattre la deuxième partie sous la première partie pour obtenir un appareil très compact où l'unité 30 est notamment située en regard du capteur 4, dans le prolongement de l'objectif.

## Revendications

1. Appareil de prise d'images (2; 3) de petites dimensions formé d'au moins une lentille optique (8, 9, 10), d'un support plat (18) présentant une ouverture (20) et d'un capteur (4) formé d'un substrat présentant une surface photosensible (6), ladite lentille optique et cette surface photosensible étant situées en regard de cette ouverture respectivement de part et d'autre dudit support qui comprend à une première face (16) des pistes conductrices et des premières plages ou plots de contact électrique, **caractérisé en ce que** ledit capteur est intégré dans un substrat semiconducteur à une face duquel sont agencées ladite surface photosensible et des deuxièmes plages de contact ou plots, **en ce que** ces deuxièmes plages de contact ou plots (28) sont situés en périphérie de ladite surface photosensible et en face desdites premières plages de contact ou plots correspondants dudit support auxquelles elles/ils sont reliés électriquement et **en ce que** ladite au moins une lentille (8, 9, 10) est agencée dans un châssis (12) ouvert à ses deux extrémités et définit ensemble avec ce dernier un objectif fixé à une seconde face (22) dudit support opposée à ladite première face (16).

2. Appareil selon la revendication 1, **caractérisé en ce qu'**il est prévu un élément optique (11) formé d'une deuxième lentille et/ou d'un filtre qui pénètre au moins partiellement dans ladite ouverture dudit support et dans ledit châssis.

3. Appareil selon la revendication 1 ou 2, **caractérisé en ce qu'**il est prévu au moins une unité électronique (30) de traitement et/ou d'exploitation des signaux électriques fournis par ledit capteur, cette unité électronique étant agencée sur ladite première face (16) dudit support (18).

4. Appareil selon l'une des revendications précédentes, **caractérisé en ce que** ledit capteur est protégé par une résine (34) déposée sur celui-ci et sur ladite première face dudit support.

## Patentansprüche

1. Bildaufnahmevorrichtung (2; 3) mit kleinen Abmessungen, die gebildet ist aus wenigstens einer optischen Linse (8, 9, 10), einem ebenen Träger (18), der eine Öffnung (20) aufweist, und einem Sensor (4), der aus einem Substrat gebildet ist, das eine lichtempfindliche Oberfläche (6) besitzt, wobei sich die optische Linse und diese lichtempfindliche Oberfläche gegenüber dieser Öffnung auf der einen bzw. auf der anderen Seite des Trägers befinden, der auf einer ersten Fläche (16) Leiterbahnen und erste Bereiche oder Höcker für einen elektrischen Kontakt umfasst, **dadurch gekennzeichnet, dass** der Sensor in ein Halbleitersubstrat integriert ist, auf dessen einer Fläche die lichtempfindliche Oberfläche und zweite Kontaktbereiche oder Höcker angeordnet sind, dass sich diese zweiten Kontaktbereiche oder Höcker (28) am Umfang der lichtempfindlichen Oberfläche und gegenüber den ersten entsprechenden Kontaktbereichen oder Höckern des Trägers befinden, mit denen sie elektrisch verbunden sind, und dass wenigstens eine Linse (8, 9, 10) in einem an seinen beiden Enden offenen Rahmen (12) angeordnet ist und zusammen mit diesem letzteren ein Objektiv definiert, das an der zweiten Fläche (22) des Trägers gegenüber der ersten Fläche (16) befestigt ist.

2. Vorrichtung nach Anspruch 1, **dadurch gekennzeichnet, dass** ein optisches Element (11) vorgesehen ist, das aus einer zweiten Linse und/oder aus einem Filter gebildet ist, das wenigstens teilweise in die Öffnung des Trägers und in den Rahmen eindringt.

3. Vorrichtung nach Anspruch 1 oder 2, **dadurch gekennzeichnet, dass** wenigstens eine elektronische Verarbeitungs- und/oder Auswertungseinheit für elektrische Signale, die von dem Sensor geliefert werden, vorgesehen ist, wobei diese elektronische Einheit auf der ersten Fläche (16) des Trägers (18) angeordnet ist.

4. Vorrichtung nach einem der vorhergehenden Ansprüche, **dadurch gekennzeichnet, dass** der Sensor durch ein Harz (34) geschützt ist, das auf diesem und auf der ersten Fläche des Trägers aufgebracht ist.

## Claims

1. Image recording apparatus (2; 3) of small dimensions formed of at least one lens assembly (8, 9, 10), a flat support (18) having an aperture (20) and a sensor (4) formed of a substrate having a photosensitive surface (6), said optical lens and said photosensitive surface being located facing said aperture respectively on either side of said support, which includes on a first face (16) conductive paths and first electric contact pads or bumps, **characterised in that** said sensor is integrated in a semiconductor substrate on one face of which are arranged said photosensitive surface and second contact pads or bumps, **in that** said second contact pads or bumps (28) are located at the periphery of said photosensitive surface and facing said first corresponding contact pads or bumps of said support to which they are electrically connected and **in that** said at least one lens (8, 9, 10) is arranged in a frame (12) open at both of its ends and defines together with the latter a lens assembly directly secured to a second face (22) of said support opposite said first face (16).

2. Apparatus according to claim 1, **characterised in that** there is provided an optical element (11) formed of a second lens and/or a filter which penetrates said aperture of said support and said frame at least partially.

3. Apparatus according to claim 1 or 2, **characterised in that** there is provided at least one electronic unit (30) for processing and/or exploiting the electric signals supplied by said sensor, said electronic unit being arranged on said first face (16) of said support (18).

4. Apparatus according to any of the preceding claims, **characterised in that** said sensor is protected by a resin (34) deposited thereon and on said first face of said support.
